# EUROPEAN PATENT APPLICATION

(11) **EP 3 937 213 A1**
(43) Date of publication of application: **12.01.2022**
(21) Application number: 19813645.9
(22) Date of filing: 24.10.2019
(51) Int. Cl.: H01L 21/48, H01L 25/00, H01L 25/16, H01L 25/11, H01L 23/28

(54) **METHODS FOR MANUFACTURING THREE-DIMENSIONAL ELECTRONIC MODULES, THREE-DIMENSIONAL ELECTRONIC MODULES**

(30) Priority: 28.12.2018 RU 2018147377
(71) Applicant: Federalnoe Gosudarstvennoe Byudzhetnoe Nauchnoe Uchrezhdenie "Nauchnoproizvodstvennyj Kompleks "Tekhnologicheskij Tsentr", Moscow 124498 (RU)
(72) Inventor: BASAEV, Aleksandr Sergeevich, Moscow (RU); SAUROV, Aleksandr Nikolaevich, Moscow (RU); SUKHANOV, Vladimir Sergeevich, Moscow (RU); KOZLOV, Sergej Nikolaevich, Moscow (RU)
(74) Representative: Sezgin, Hatice Özlem
(86) International application number: PCT/IB2019/059117
(87) International publication number: WO 2020/136459

(57) **Abstract**

The group of inventions relate to the field of the assembling electronic components into an electronic module by arranging them in three-dimensional space, in particular, to a method of assembling a three-dimensional electronic module. The method of assembling a three-dimensional electronic module is as follows. The functional units are created, the electronic components are implemented mounting onto the technological substrates with contact pads on their side faces. the formed on the substrate functional units are tested. The technological casting tool is prepared for. The functional units are positioned in the technological casting tool placing the technological substrates parallel to each other into technological casting tool and superposing the contact pads. The head-conductive insulating compound is prepared, the compound is filed into the prepared technological casting tool and it is polymerized. The side faces are cutted to open the contact pads of technological substrates.The cleaning procedure of electronic module is carry out. The continuous surface metallization is formed by the screen-printing. Next, A laser is used to form the final individual paths of surface metallization on the side faces. The portions of the conductive paste are locally removed by the laser beam, thereby forming individual metallization paths commutating the necessary contact pads according to the electrical circuit of the three-dimensional electronic module. Also the variants of the method of manufacturing a three-dimensionalelectronic module are declared, in which the surface metallizationis formed by galvanic method and the method of three-dimensional printing, and the three-dimensional electronic modules manufactured by the proposed methods are declared. The technical result is to increase the reliability of three-dimensional electronic modules.

## Description

### Field of the invention

The invention relates to the field of the assembling electronic components into an electronic module by arranging them in three-dimensional space, in particular, to a method of assembling a three-dimensional electronic module.

### Background

Three-dimensional electronic module with ball leads (RU 2312425 C1, (Yuri Dmitrievich Sasov), 2007.12.10) consisting of individual unpackaged electronic components and/or microplates, with components, is known in the prior art. The individual unpackaged components and/or microplates are located parallel to each other and have the mutual electrical and mechanical connection, and the module is protected by a sealing shell and has external terminals. The module comprises at least one module-shaping individual unpackaged electronic component largest in terms of size, and the remaining unpackaged electronic components are disposed in holes of microplate substrates, having plan dimensions equal to the dimensions of the maximum individual unpackaged electronic component size. The accuracy of dimensions in relation to the individual components, as well to the microplates should ensure their subsequent oriented adhesion in a package. All components comprised in the microplate and the individual components are interconnected by conductors, preferably made by vacuum coating, that are disposed on the front, end and back surfaces of the microplate and the individual components, wherein the conductors facing the end surfaces of the microplates and the individual components are used both for connecting the components located on the front and back sides of the microplates and the individual components, and for subsequently joining them together. The microplates and/or the individual components circumferentially adhered together in the package are oriented onto the conductors disposed at their end faces, and are define by their end surfaces at least one common plane to subsequently form external leads. Over the surfaces of the package there are the conductors connecting the microplates and/or individual components electrically, and one of the surfaces simultaneously defining the contact pads for the subsequent formation of the external ball leads. Wherein the conductors are made preferably by vacuum coating, sealing shell has the necessary mechanical and electrical insulating properties and has the holes uninsulated in places of the subsequent formation of external leads. On the package surface defined by the ends of the microplates and/or individual components, the ball external leads are arranged in the holes of the sealing shell formed or fixed by standard ways. The disadvantage of said three-dimensional electronic module is that the module is sealed with a sealing shell, by which the module is coated after its assembling, which increases its manufacturing complexity, consisting in the fact that after all the assembly operations of the module it is necessary to carry out a sealing operation yet.

A method of assembling a three-dimensional electronic module (RU 2492549 C1, (Federal state budgetary institution of higher professional education «Bauman Moscow State Technical University» , 2013.09.10), is known in the prior art, the method comprising: placing electronic components and microplates having contact pads on the end surfaces parallel to each other, their electrical connecting on the side surfaces of the three-dimensional electronic module, its controlling and sealing. Wherein before assembling the three-dimensional electronic module the spatially oriented contact pads are formed on the mating surfaces of the reliably suitable electronic components in order to create a continuous line of the module structure. Then an adhering heat-conductive electrically insulating composition are metered to the ends of the microplates, while ensuring the integrity and continuity of the adhesive joint, superposed over the contact pads of the electronic components and connected them. Then an adhesive composition is polymerized, and the contact pads of electronic components and microplates are purified from the adhesive composition film. Then the conductors are coated on the sides of the glued three-dimensional electronic module, providing the necessary connections between the electronic components and microplates over their contact pads, and conductors are built-up located on the sides of the three-dimensional electronic module. The disadvantage of this method is the complexity of the assembling the three-dimensional electronic module and the reduction of its reliability, since in the microplates of the proposed method are adhered on the ends while superposing electron components on the contact pads, due to which it is impossible to obtain a flat surface for subsequent electrical connecting the contact pads of the microplates using conductors, which will affect the quality of the connections between them.

A method for assembling a three-dimensional electronic module WO 0159841, (3D PLUS et al.),2001.08.16, is known in the prior art, the method comprising stacking and assembling (100; 100') elements to be interconnected, cutting (101; 101') through the housing or housings adjacent said components to form a block (6; M), leaving flush with the connection conductors of the section, performing (102; 102') electrical connections between the conductors of different elements on the faces of said block. The disadvantage of this method is the reduction of the reliability and quality of the three-dimensional electronic module due to the lack of operations for preparing the compound and the casting tool.

A method for assembling a three-dimensional electronic module (US 9659846 B2, (3D PLUS), 2017.05.23) is taken as a prototype and it is as follows. A stack of electronic packages and/or printed wiring boards is assembled. A stack is placed on a lead frame that comprises metal leads, each having two ends, one toward the interior of the frame and the other toward the exterior of the frame. Internal lead ends are folded by about 180°, in order to obtain internal portion, including the folded ends, which are intended to be moulded. The other portion, which is what is referred to as an external portion, including unfolded exterior ends, the two ends of each lead being intended to emerge from the 3D module on a given face cut along Z. The leads are deposed with a metal coating compatible with subsequent steps of adhesive bonding and/or soldering of the external portion. The external portion of the metallized frame is placed between a lower protective element and an upper protective element, while leaving the internal portion free, and placing the frame and the protective elements on a carrier. Each stack of packages and/or printed wiring boards are placed equipped each with at least one electronic component and exterior tabs for electrically interconnecting packages and/or printed wiring boards, so as to superpose the exterior tabs on the metal leads of the internal portion. The stack of electronic packages and/or printed wiring boards are molding, in an epoxy resin, covering the exterior tabs and the internal portion and thereby partially covering the upper protective element. The resin is cut thereby forming faces, thereby leaving flush conductive sections of the exterior tabs and of the ends of the metal leads of the internal portion, and removing the resin from the upper protective element. The cut faces are metallized and the carrier and protective elements are removed, in order to expose the leads of the external portion. The disadvantage of this assembling method is the etching of the metallized cut faces for electric interconnecting the packages and/or printed wiring boards, which can lead to poor contact between printed wiring boards and affect the total reliability of the three-dimensional electronic module.

The objective of the claimed invention is to develop a method of assembling a three-dimensional module, which will improve the reliability of a three-dimensional electronic module.

### Summary of the invention

The technical result of the claimed invention is to increase the reliability of three-dimensional electronic modules produced by the proposed methods, due to preparing the technological casting tool preventing adhesion of the compound; preparing the compound reducing the likelihood of the defect formation inside the three-dimensional electronic module, and forming individual metallization paths increasing the quality and reliability of the contacts between the metallization layer and the contact pads.

The technical result is obtained by mounting obviously -suitable electronic components onto the technological substrates having the contact pads at their side faces, placing the technological substrates parallel to each other into technological casting tool and superposing the contact pads, filling the tool with the compound and polymerizing it, cutting-off the side faces of the formed electronic module to open the contact pads of the technological substrates, cleaning the surfaces of the electronic module, applying the conductive paste onto the surfaces of the electronic module by screen-printing and annealing it, removing the paste layer locally with a laser beam, thereby forming individual paths of the surface metallization electrically connecting the individual contact pads of the technological substrates at the side faces of the three-dimensional module.

This method for assembling is based on the use of the reliably suitable electronic components. Technological substrates having the contact pads on their side faces are used, which subsequently help to implement electrically connect several functional units. The functional unit formed on the substrate is tested after mounting the electronic components onto the technological substrates. The functional unit is tested by specialized control and measuring equipment which is applicable for a particular product construct. In the case of the failure in the operation of the unit or a component defect, the functional unit is analyzed and the defective components are replaced. Then the testing of the functional unit is repeated, and the electronic module is following assembled if the testing is passed with a positive result, when there are no failures in the operation of the functional unit and/or defect of the electronic component.

The next step of the assembling is the preparing of the technological casting tool for the operation of filling and polymerizing of a heat-conducting electrical insulating compound. To prevent the adhesion of the compound to the surfaces of the tool and to easily remove the finished electronic module after the compound polymerizing, it is necessary to clean the tool from foreign substances and contaminants, to dry the tool and to apply the release agent having anti-adhesive properties. The technological tool is cleaned by washing in special solvent liquids selected for the material of the tool itself. Generally, alcohol is used for this purpose as it is a universal solvent for many organic substances. After cleaning, the technological tool is dried at the elevated temperature, followed by the operation of applying the release agent. Several types of the release agent can be used: on the oil, silicone or wax base. A uniform thin layer of the release agent is applied onto the surfaces of the tool by spraying.

The technological substrates with the checked electronic components mounted on them, are positioned in the technological tool. The substrates are positioned "by floors", one above the other. With this positioning of the substrates, their parallelism is of great importance since the superposition of contact pads depends on it. The contact pads of the technological substrates are positioned as accurately as possible, one above the other.

The next step is preparing head- conductive insulating compound and filling it into the prepared technological casting tool, in which the technological substrates are located. The preparation of the multicomponent compound is carried out in any known manner.

Defects (gas bubbles in the volume of the compound) may form when preparing the compound. The presence of these defects has extremely negative effect on the finished product since the compound structure is no longer monolithic, and the mechanical strength with its accompanying characteristics is reduced. If the compound is highly defective, cracks violating the tightness of the internal components of the electronic module may possibly occur. A double degassing operation in vacuum is used to prevent the formation of the gas bubbles in the volume of the compound: degassing of the compound immediately after the preparing, then degassing after filling the compound into the technological tool. In vacuum gas bubbles are expand and pushed out of the volume onto the surface of the liquid compound, thereby reducing the likelihood of defect formation inside the electronic module. To increase the fluidity and to decrease the viscosity of the liquid compound, and, consequently, to better fill the volume of the tool and small cavities between the electronic components on the technological substrates, it is possible to preheat the compound before degassing. Preheating is not used with all types of compounds; the temperature increasing will be a polymerization catalyst for some types of compounds, leading to premature curing of the composition. The most technologically adaptable variant of the filling operation is the use of an automated vacuum system in which the technological tool is located in a low pressure vacuum chamber, and the degassed liquid compound is supplied to the tool through a dispenser.

The compound is polymerized. The compounds are divided according to the cold and hot curing. When using a hot curing compound, it is necessary to take into account the maximum possible temperature of affecting the electronic components and the technological casting tool. The temperature of the technological compound curing process must not exceed the maximum temperature affecting the components and the tool. Most of the hot curing compounds have a complex temperature profile of polymerization; therefore, cabinet dryers or climatic devices capable to programmatically set the temperature mode consisting of several stages are used for this process.

After polymerization of the compound, the electronic module is removed from the technological tool. If you do not pay due attention to the separation coatings at the step of preparing the casting mold, there is a probability to damage the module when it is removed, due to the adhesion of the compound.

The following step is the cutting-off operation of the formed three-dimensional electronic module. The cutting-off is necessary to open the contact pads of the technological substrates that have been remained in the volume of the compound as a result of the previous operation. Cutting-off is carried out by means of equipment that allows to ensure minimal surface roughness of the side ends of the three-dimensional electronic module. A cut is made from the side faces of the formed three-dimensional electronic module. For this operation it is used high-speed programmable cutoff machines which can control the speed of rotation of the cutting disc and move the electronic module on a platform. There are also applicable high-speed CNC (computerized numerical control) milling machines, in which the electronic module is installed and processed along the perimeter by the operator program. The surface roughness of the side ends of the module, which affects the metallization process, depends on the used tool. The maximum adhesion of the metal conductive layer to the cured compound and to the contact pads of technological substrates is achieved at minimum surface roughness.

Before the operation of forming continuous surface metallization, the electronic module undergoes the cleaning procedure to exclude the influence of possible contaminants on the quality of the conductive layer. The cleaning procedure of a three-dimensional electronic module can be carried out in jet washing devices and ultrasonic baths.

Next, the continuous surface metallization is formed by the screen-printing. For this, a highly conductive polymeric paste based on silver of high fineness of grind is applied onto the prepared surfaces of the three-dimensional electronic module through a screen in the form of a grid with a small number of threads per unit area. This is necessary for the unobstructed penetration of the paste through the screen cells. The thickness of the surface coating with the paste depends on the used screens. After applying, the paste is cured in the cabinet dryer or in the climatic chamber.

The obtained continuous surface metallization connects and shorts the contact pads of all functional units located inside the electronic module. A laser is used to form the final individual paths of surface metallization. The portions of the conductive paste are locally removed by the laser beam, thereby forming individual metallization paths commutating the necessary contact pads according to the electrical circuit of the three-dimensional electronic module. Laser parameters are as follows: power, duration and frequency of the pulse, the rate of movement of the laser beam, are chosen to ensure the removal of the metallization layer throughout its depth, and minimal influence on the underlying surface of the compound.

The formation of continuous surface metallization can also be performed by electroplating. The use of electroplating includes the following typical operations: degreasing the surface of the electronic module, etching the epoxy resin compound, washing, re-degreasing, and sensitizing the surface, then activating it and nickel plating.

The alternative to the screen-printing and electroplating using the applying continuous metallization is three-dimensional printing of the metallization paths using electrically conductive materials. By three-dimensional printing of the necessary individual paths of surface metallization commutating the contact pads of the technological substrates are immediately formed without using a laser.

Thus, the proposed methods produce the three-dimensional electronic modules having high reliability and high radiation resistance, chemical resistance, resistance to climatic factors, and mechanical strength.

### Brief description of the drawings

Fig. 1 is a functional unit produced by mounting obviously - suitable electronic components onto the technological substrates.
Fig. 2 shows assembling the functional units into a package (stack).
Fig. 3 shows arrangement of the package (stack) of functional units in the technological tool.
Fig. 4 is a formed three-dimensional electronic module after polymerization of the compound.
Fig. 5 is a three-dimensional electronic module after cutting-off the side faces.
Fig. 6 is a three-dimensional electronic module with continuous surface metallization.
Fig. 7 is a finished three-dimensional electronic module with individual paths of surface metallization.

### Implementation of the invention

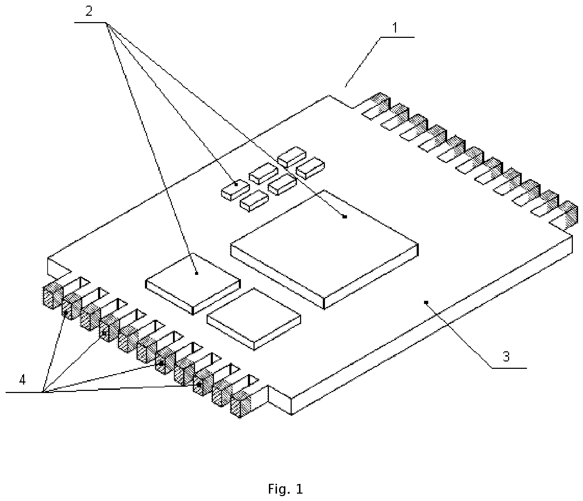

Fig. 1 shows the functional unit 1 produced by mounting the electronic components 2 onto the technological substrate 3. The technological substrate 3 has the contact pads 4 on its side faces, which subsequently help to implement electrical connection of the several functional units 1. The proposed method for producing three-dimensional electronic module uses obviously suitable electronic components 2. The functional unit 1 formed on the substrate is tested after mounting the electronic components 2 onto the technological substrates 3. In case of failure of the operation of the unit or a component defect, the functional unit 1 is analyzed and the defective components are replaced. Then, the testing of the functional unit 1 is repeated, and the following assembling of the three-dimensional electronic module is carried out only if the test is positive.

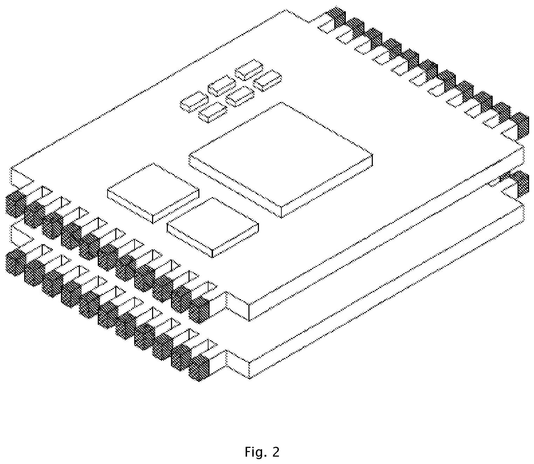

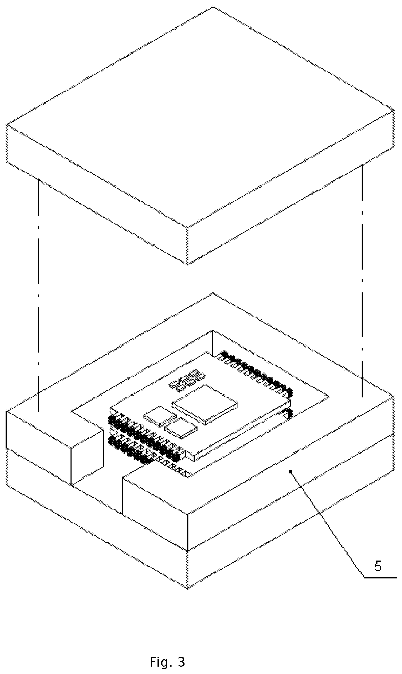

As shown in Fig. 2 at least two functional units 1 are stacked in the package (stack) parallel to each other («by floors»). It is very important that the contact pads 4 of the technological substrates 1 are located as accurately as possible, one above the other. Then, said functional units 1 are placed in the technological tool 5 prepared previously (Fig. 3).

The preparing of the technological casting tool 5 for the filling and polymerizing operations of a heat-conducting electrical insulating compound is performed to prevent the compound from adhering to the surfaces of the tool and to simply remove the finished electronic module after polymerization of the compound. The technological casting tool 5 is cleaned with alcohol from foreign substances and contaminants, then drying the technological casting tool at the elevated temperature, next applying a release agent on the oil, silicone or waxes base, which has anti-adhesive properties. In this case, the uniform thin layer of the release agent is applied onto the surfaces of the tool by spraying. Then, a heat-conducting electrically insulating compound is prepared and filled into the prepared technological casting tool, in which the technological substrates are located. When preparing the compound, in order to prevent the formation of gas bubbles in the volume of the compound it is used the double degassing operation in vacuum, at which the compound is degassed immediately after the preparing, and then degassed after filling it into the technological tool. Under vacuum, gas bubbles are pushed out of the volume onto the surface of the liquid compound, thereby reducing the likelihood of defect formation inside the electronic module.

Then the compound is filled into the technological tool and carried out its polymerization. An automated vacuum system is used to fill the compound, in which the technological casting tool is placed in a low pressure vacuum chamber, and the degassed liquid compound is supplied to the tool through a dispenser. The claimed method can use hot curing compounds and cold curing compounds. When using a hot curing compound, it is necessary to take into account the maximum possible temperature affecting the electronic components and the technological casting tool. It is important that the temperature of the technological compound curing process does not exceed the maximum temperature affecting the components and the tool. For hot curing compounds, cabinet dryers or climatic devices capable to programmatically set the temperature mode consisting of several stages are used.

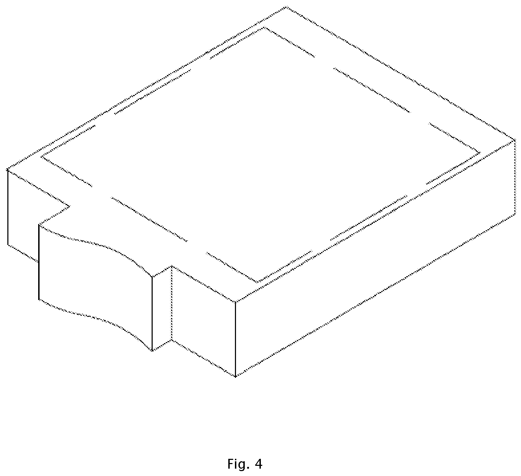

After polymerization of the compound, the electronic module is removed from the technological tool. The formed three-dimensional electronic module is shown in Fig. 4.

Then the side faces are cut off using high-speed programmable cut-off machines or high-speed CNC (computerized numerical control) milling machines to open the contact pads 4 of the technological substrates 3 that remained in the volume of the compound as a result of filling the compound.

In this case, to exclude the influence of possible contaminants on the quality of the conductive layer, before the formation of surface metallization the cleaning procedure of a three-dimensional electronic module is carried out in the jet washing device and ultrasonic baths.

Next, the continuous surface metallization is formed, and in the first embodiment of the method for producing the three-dimensional electronic module, the screen printing is used to form the continuous surface metallization. For this purpose, a highly conductive polymeric paste based on silver of high fineness of grind is applied onto the prepared surfaces of the three-dimensional electronic module through a screen in the form of a grid with a small number of threads per unit area. This is necessary for the unobstructed penetration of the paste through the screen cells. The thickness of the surface coating with the paste depends on the used screens. After applying, the paste is cured in the cabinet dryer or in the climatic chamber.

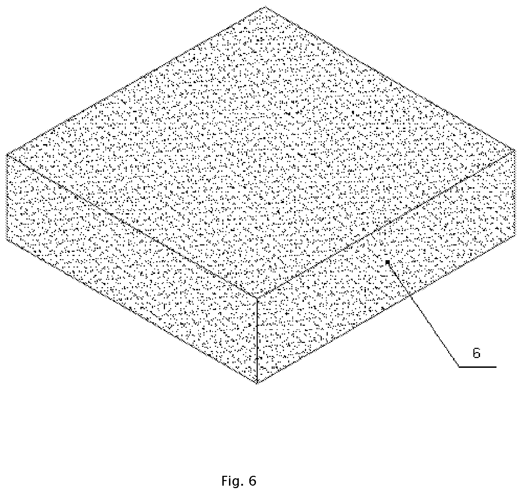

The finished three-dimensional electronic module with continuous surface metallization is shown in Fig. 6.

The obtained continuous surface metallization 6 connects and shorts the contact pads 4 of all functional units 1 located inside the electronic module. A laser is used to form the final individual paths of the surface metallization. The portions of the surface metallization 6 on the side faces are locally removed by the laser beam, thereby forming the individual metallization paths 7 commutating the necessary contact pads 4 according to the electrical circuit of the three-dimensional electronic module.

In the second embodiment of invention the formation of the continuous surface metallization is performed by electroplating. The method includes the following typical operations: degreasing the surfaces of the three-dimensional electronic module, etching the epoxy resin compound, washing, re-degreasing, and sensitizing the surface, then its activing and nickel plating.

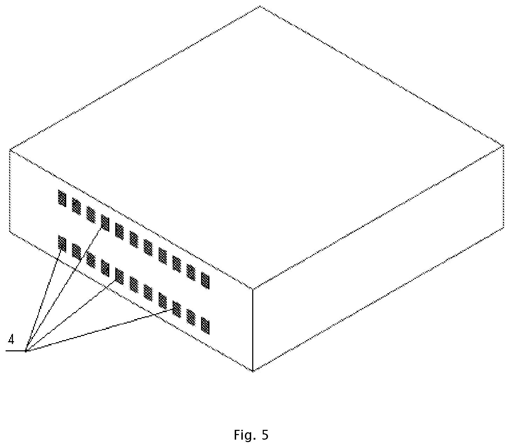

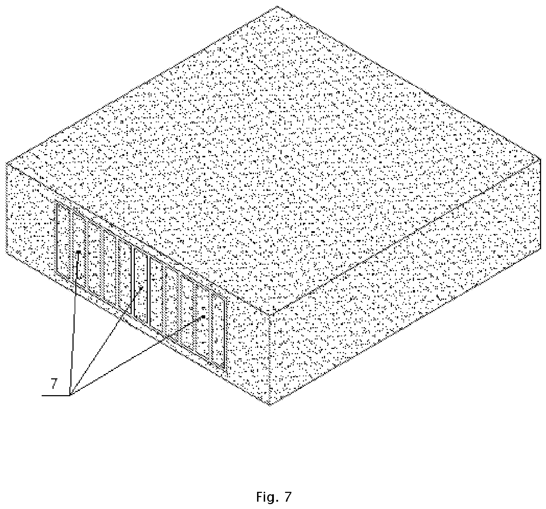

In the third embodiment of the invention the necessary individual paths of surface metallization are formed immediately by three-dimensional printing of the electrically conductive material on the surface of the electronic module without using a laser. In this embodiment after Fig. 5 immediately follows Fig. 7.

The three-dimensional electronic module produced by the embodiments of proposed method shown in Fig. 7, comprises a package (stack) of at least two functional units formed by mounting of the electronic components onto the technological substrates with the contact pads on their side faces.

## Claims

1. A method for producing a three-dimensional electronic module comprising the following steps:
creating functional units by mounting electronic components onto technological substrates with contact pads on their side faces,
testing the function unit formed on the substrate, with a positive test result of which the following steps is carried out,
preparing the technological casting tool by cleaning it from foreign substances, contaminations, drying and applying a release agent that has anti-adhesive properties,
positioning the functional units in the technological casting tool, placing them parallel one to another, and superposing the contact pads,
preparing a heat-conducting electrical insulating compound and filling the compound into the technological casting tool,
when preparing and filling the heat-conductive insulating compound, the double degassing operation is used,
polymerizing the heat-conducting conductive insulating compound,
cutting-off the side faces of the formed three-dimensional electronic module to open the contact pads of the technological substrates by equipment that allows to ensure the minimum surface roughness of the side ends of the three-dimensional electronic module,
cleaning the three-dimensional electronic module from possible contaminants,
forming continuous surface metallization by screen printing,
removing locally the portions of the surface metallization on the side faces using a laser beam, thereby forming individual metallization paths, commutating the necessary contact pads according to the electrical circuit of the three-dimensional electronic module.

2. The method for producing a three-dimensional electronic module according to claim 1, wherein the technological casting tool is cleaned by special solvents selected for the material of the tool, and the release agent is applied as a uniform thin layer onto the surfaces of the tool by spraying.

3. The method for producing a three-dimensional electronic module according to claim 2, wherein the technological casting tool is cleaned with alcohol.

4. The method for producing a three-dimensional electronic module according to claim 2, wherein as a release agent it is used the release agent on the oil, silicone or waxes base.

5. The method for producing a three-dimensional electronic module according to claim 1, wherein the double degassing operation is carried out in vacuum by degassing the compound immediately after the preparing, then degassing after filling the compound into the technological casting tool.

6. The method for producing a three-dimensional electronic module according to claim 1, wherein to fill the compound into the technological casting tool it is used an automated vacuum system in which the technological casting tool is located in a low pressure vacuum chamber, and the degassed liquid compound is supplied to the tool through a dispenser.

7. The method for producing a three-dimensional electronic module according to claim 1, wherein the cleaning procedure of the three-dimensional electronic module is carried out in jet washing devices and ultrasonic baths.

8. The method for producing a three-dimensional electronic module according to claim 1, wherein as the equipment that allows to ensure minimal surface roughness of the side ends of the three-dimensional electronic module it is used a high-speed programmable cut-off machines which can control the speed of rotation of the cutting disc and move the electronic module on a platform, or high-speed programmable cut-off machines or high-speed milling machines with programmable numerical control.

9. The method for producing a three-dimensional electronic module according to claim 1, wherein screen-printing is carried out by applying a highly conductive polymeric paste based on silver of high fineness of grind onto the prepared surfaces of the three-dimensional electronic module through a screen in the form of a grid with a small number of threads per unit area, then curing the applied paste.

10. The three-dimensional electronic module comprising a package of at least two functional units formed by mounting of the electronic components onto the technological substrates with the contact pads on their side faces, made by the method of claims 1 to 9.

11. A method for producing a three-dimensional electronic module, comprising the following steps:
creating functional units by mounting electronic components onto technological substrates with contact pads on their side faces,
testing the function unit formed onto the substrate, with a positive test result of which the following steps carried out,
preparing the technological casting tool by cleaning it from foreign substances, contamination, drying and applying a release agent that has anti-adhesive properties,
positioning the functional units in the technological casting tool, placing them parallel one to another, and superposing the contact pads,
preparing a heat-conducting electrical insulating compound and filling the compound into technological casting tool,
when preparing and filling the heat-conducting insulating compound, the double degassing operation is used,
polymerizing the heat-conducting insulating compound,
cutting-off the side faces of the formed three-dimensional electronic module to open the contact pads of the technological substrates by equipment that allows to ensure the minimum surface roughness of the side ends of the three-dimensional electronic module,
cleaning the three-dimensional electronic module from possible contaminants,
forming a continuous surface metallization by screen printing,
removing locally the portions of the surface metallization on the side faces using a laser beam, thereby forming individual metallization paths, commutating the necessary contact pads according to the electrical circuit of the three-dimensional electronic module.

12. The method for producing a three-dimensional electronic module according to claim 11, wherein the technological casting tool is cleaned by special solvents selected for the material of the tool, the release agent is applied as a uniform thin layer onto the surfaces of the tool by aerosol method.

13. The method for producing a three-dimensional electronic module according to claim 12, wherein the casting tool is cleaned with alcohol.

14. The method for producing a three-dimensional electronic module according to claim 12, wherein as a release agent it is used the release agent on the oil, silicone or waxes base.

15. The method for producing a three-dimensional electronic module according to claim 11, wherein a double degassing operation is carried out in vacuum by degassing the compound immediately after the preparing, then degassing after filling the compound into the technological tool.

16. The method for producing a three-dimensional electronic module according to claim 11, wherein to fill the compound into the technological casting tool it is used an automated vacuum system in which the technological casting tool is located in a low pressure vacuum chamber, and the degassed liquid compound is supplied to the tool through a dispenser.

17. The method for producing a three-dimensional electronic module according to claim 11, wherein the cleaning procedure of the three-dimensional electronic module is carried out in jet washing devices and ultrasonic baths.

18. The method for producing a three-dimensional electronic module according to claim 11, wherein as the equipment that allows to ensure minimal surface roughness of the side ends of the three-dimensional electronic module it is used a high-speed programmable cut-off machines which can control the speed of rotation of the cutting disc and move the electronic module on a platform, or high-speed programmable cut-off machines or high-speed milling machines with programmable numerical control.

19. The method for producing a three-dimensional electronic module according to claim 11, wherein electroplating for forming the surface metallization is performed by degreasing the surfaces of the three-dimensional electronic module, etching the epoxy resin compound, washing, re-degreasing, and sensitizing the surface, then its activating and nickel plating.

20. A three-dimensional electronic module comprising a package of at least two functional units formed by mounting of the electronic components onto the technological substrates with the contact pads on their side faces, made by the method of claims 11 to 19.

21. The method for producing a three-dimensional electronic module, comprising the following steps:
creating functional units by mounting electronic components onto technological substrates with contact pads on their side faces,
testing the function unit formed onto the substrate, with a positive test result of which the following steps are carried out,
preparing the technological casting tool by cleaning it from foreign substances, contaminations, drying and applying a release agent that has anti-adhesive properties,
positioning the functional units in the technological casting tool, placing them parallel one to another, and superposing the contact pads,
preparing a heat-conducting electrical insulating compound and filling the compound into the technological casting tool,
when preparing and filling the heat-conducting insulating compound, the double degassing operation is used,
polymerizing the heat-conducting insulating compound,
cutting-off the side faces of the formed three-dimensional electronic module to open the contact pads of the technological substrates by equipment that allows to ensure the minimum surface roughness of the side ends of the three-dimensional electronic module,
cleaning the three-dimensional electronic module from possible contaminants,
forming by three-dimensional printing of the individual paths of surface metallization commutating the contact pads of the technological substrates according to the electrical circuit of the three-dimensional electronic module.

22. A method for producing a three-dimensional electronic module according to claim 21, wherein the technological casting tool is cleaned by special solvents selected for the material of the tool, the release agent is applied as a uniform thin layer onto the surfaces of the tool by spraying.

23. The method for producing a three-dimensional electronic module according to claim 22, wherein the casting tool is cleaned with alcohol.

24. The method for producing a three-dimensional electronic module according to claim 22, wherein as a release agent it is used the release agent on the oil, silicone or waxes base.

25. The method for producing a three-dimensional electronic module according to claim 22, wherein a double degassing operation is carried out in vacuum by degassing the compound immediately after the preparing, then degassing after filling the compound into the technological tool.

26. The method for producing a three-dimensional electronic module according to claim 21, wherein to fill the compound into the technological casting tool it is used an automated vacuum system in which the technological casting tool is located in a low pressure vacuum chamber, and the degassed liquid compound is supplied to the tool through a dispenser.

27. The method for producing a three-dimensional electronic module according to claim 21, wherein the cleaning procedure of the three-dimensional electronic module from possible contaminants is carried out in jet washing devices and ultrasonic baths.

28. The method for producing a three-dimensional electronic module according to claim 21, wherein as the equipment that allows to ensure minimal surface roughness of the side ends of the three-dimensional electronic module it is used a high-speed programmable cut-off machines which can control the speed of rotation of the cutting disc and move the electronic module on a platform, or high-speed programmable cut-off machines or high-speed milling machines with programmable numerical control.

29. The method for producing a three-dimensional electronic module according to claim 21, wherein the formation of individual paths of surface metallization commutating the necessary contact pads according to the electrical circuit of the three-dimensional electronic module is carried out by three-dimensional printing using electrically conductive materials.

30. A three-dimensional electronic module comprising a package of at least two functional units formed by mounting of the electronic components onto the technological substrates with the contact pads on their side faces, made by the method of claims 21 to 29.
